# EUROPÄISCHE PATENTSCHRIFT

(11) **EP 3 026 133 B1**
(45) Veröffentlichungstag und Bekanntmachung des Hinweises auf die Patenterteilung: **09.08.2017**
(21) Anmeldenummer: 15196034.1
(22) Anmeldetag: 24.11.2015
(51) Int. Cl.: C22C 1/00, C22C 14/00, C22C 1/02

(54) **SCHMELZVERFAHREN FÜR LEGIERUNGEN**
MELTING METHOD FOR ALLOYS
PROCEDE DE FUSION POUR ALLIAGES

(30) Priorität: 27.11.2014 DE 102014117424
(43) Veröffentlichungstag der Anmeldung: 01.06.2016
(73) Patentinhaber: Ald Vacuum Technologies GmbH, 63457 Hanau (DE)
(72) Erfinder: Flinspach, Jochen, 63454 Hanau (DE); Kunde, Frank, 63477 Maintal (DE); Hanselmann, Thomas, 63571 Gelnhausen (DE); Mangelsen, Markus, 63674 Altenstadt (DE)
(74) Vertreter: Fuchs Patentanwälte Partnerschaft mbB

(56) Entgegenhaltungen:
- EP-A1- 1 598 434
- EP-A2- 1 006 205
- DE-A1-102010 018 303
- DE-T2- 69 019 428
- DE-T2- 69 216 171

## Beschreibung

Die vorliegende Erfindung betrifft ein Verfahren zur Herstellung von Metalllegierungen.

Die Herstellung von Metalllegierungen ist besonders anspruchsvoll, wenn die verwendeten Ausgangskomponenten hohe Schmelzpunktunterschiede aufweisen. In solchen Fällen kann es vorkommen, dass diejenige Ausgangskomponente mit dem niedrigeren Schmelzpunkt verdampft, wenn die für das Schmelzen der anderen Komponente notwendige Temperatur eingestellt wird.

Aus dem Stand der Technik sind Verfahren bekannt, die einen Festkörper des höher schmelzenden Materials in eine Schmelze des niedriger schmelzenden Materials einbringen. Das höher schmelzende Material wird dann von der Schmelze langsam aufgezehrt. Dieser Prozess ist sehr langwierig und damit kostenintensiv. Außerdem bleibt das niedriger schmelzende Material für lange Zeit bei hoher Temperatur, was die Verdampfung begünstigt.

Eine alternative Methode sieht das gemeinsame Verpressen von entsprechenden Metallpulvern und anschließendes Sintern des Presskörpers vor. Dieses Verfahren ist schon aufgrund des Mahlens und der benötigten Energie für das Sintern nachteilig.

DE 692 16 171 T2 beschreibt ein Verfahren zum Schmelzen von Titanaluminid-Legierungen, bei dem die Sauerstoffaufnahme der Legierung während der Schmelze in einem Calciumoxid-Keramiktiegel minimiert werden soll. Um das zu erreichen, wird der Legierung Niob zugesetzt. Das dort beschriebene Verfahren sieht vor, zunächst unter anderem die Komponenten Aluminium und Niob aufzuschmelzen. Das Titan wird dann zu der Schmelze gegeben. Es wird auch ein alternatives Verfahren beschrieben, bei dem die Ausgangsmetalle in fester Form in den Tiegel gegeben werden. Dabei wird Titan als Feststoff auf die anderen Komponenten gegeben. Damit soll der Effekt erreicht werden, dass das Titan als letztes schmilzt und somit nur für sehr kurze Zeit dem Keramiktiegel ausgesetzt ist. Die Charge wird mit konventionellen Methoden wie Induktions-, Plasma-, Bogen- oder Widerstandsheizern erhitzt. Die in diesem Dokument beschriebene Methode arbeitet unter Normaldruck und ggf. unter Schutzgas wie Argon. Der Schmelzpunkt von Titan beträgt bei Normaldruck ca. 1660 °C, der von Aluminium lediglich 660 °C. Somit schmilzt das Aluminium zuerst. Allerdings siedet Aluminium erst bei 2470 °C. Folglich stellt sich das Problem der Verdampfung des niedrigschmelzenden Metalls hier nicht. Die Sauerstoffgehalte der so hergestellten Legierungen liegen deutlich über 400 ppm.

Ein geringer Sauerstoffgehalt wirkt sich positiv auf die Duktilität der Legierung aus. Gemäß der vorliegenden Erfindung soll der geringere Sauerstoffgehalt durch Schmelzen der Legierung unter Vakuum erzielt werden. Unter Vakuum wird die Verarbeitung von Metallen mit hohen Schmelzpunktunterschieden allerdings sehr problematisch. Naturgemäß sinkt der Siedepunkt eines Stoffes unter Vakuum stärker als der Schmelzpunkt. Dadurch rückt der Siedepunkt des niedriger schmelzenden Metalls näher an die erforderliche Schmelztemperatur der herzustellenden Legierung. Dieser Effekt ist umso ausgeprägter, je geringer der Druck ist. Folglich steigen die Verdampfungsverluste bei der Herstellung der Legierung mit sinkendem Druck. Gleichzeitig steigt die Reinheit im Hinblick auf flüchtige Verunreinigungen und der Sauerstoffgehalt nimmt insgesamt ab.

Ein besonderer Vorteil ist, dass in einem Vakuumschmelzverfahren auch Rohstoffe eingesetzt werden können, die Verunreinigungen enthalten. Diese können schließlich in der Schmelze aufgrund des Vakuums entfernt werden.

Es ist folglich die Aufgabe der vorliegenden Erfindung, ein Verfahren bereit zu stellen, das die Herstellung von Metalllegierungen ermöglicht, die wenigstens zwei Metalle mit hohem Schmelzpunktunterschied aufweisen. Das Verfahren soll den Einsatz von verunreinigten Ausgangskomponenten (z.B. recyceltes Metall) ermöglichen und Metalllegierungen mit hoher Reinheit bei geringem Verdampfungsverlust erhältlich machen.

Die vorliegende Erfindung löst diese Aufgaben.

Das Verfahren dieser Erfindung ist ein Verfahren zur Herstellung einer Metalllegierung, die insbesondere als Masteralloy verwendet werden kann. Die Legierung enthält wenigstens zwei Metalle als Ausgangskomponenten. Das Verfahren umfasst die folgenden Schritte:
a. Bereitstellen eines Festkörpers eines ersten Metalls oder einer ersten Metalllegierung in einem Tiegel,
b. Hinzufügen eines zweiten Metalls auf den Festkörper im Tiegel,
c. Schmelzen des zweiten Metalls,
wobei der Schmelzpunkt des zweiten Metalls höher ist als der Schmelzpunkt des ersten Metalls bzw. der ersten Metalllegierung und wenigstens das Schmelzen des zweiten Metalls unter Vakuum stattfindet. Um die gewünschte Legierung zu erhalten, wird auch der Festkörper wieder aufgeschmolzen. Das erste Metall bzw. die erste Metalllegierung befindet sich aber nur relativ kurz im geschmolzenen Zustand, was den Verdampfungsverlust deutlich verringert. Das Bereitstellen des Festkörpers kann in dem Bereitstellen von mehr als einem Festkörper bestehen.

Das erste Metall wird als Festkörper vorgelegt, da das zweite Metall in der Regel eine höhere Dichte hat als das erste. Würde das zweite Metall auf die Schmelze des ersten Metalls aufgebracht, würde das zweite Metall absinken und der erfindungsgemäße Erfolg nicht eintreten.

Die Metalllegierung wird vorzugsweise unter Vakuum erschmolzen. Unter Vakuum wird ein absoluter Druck von weniger als 1 bar verstanden, bevorzugt weniger als 100 mbar, weiter bevorzugt weniger als 10 mbar, mehr bevorzugt weniger als 1 mbar und besonders bevorzugt weniger als 0,01 mbar. Natürlich kann das Verfahren auch bei anderen Drücken durchgeführt werden. Die besonderen Vorteile der Erfindung treten bei Unterdruck aufgrund der verschärften Verdampfungsprobleme besonders zutage.

Vorzugsweise erfolgt die Wärmezufuhr von oben. Die Wärmezufuhr erfolgt vorzugsweise unter Verwendung einer Elektronenstrahlkanone. Zwar sind auch andere Wärmequellen denkbar, insbesondere solche, die eine Wärmezufuhr von oben ermöglichen; die Elektronenstrahlkanone bietet aber den Vorteil, dass der Elektronenstrahl besonders gut auf das zweite Metall fokussiert werden kann, wenn dieses auf dem Festkörper liegt.

Aufgrund der Wärmezufuhr von oben wird das auf dem ersten Metall bzw. der ersten Metalllegierung liegende zweite Metall verstärkt aufgeheizt. Das zweite Metall erreicht also früher die für seine Schmelze erforderlichen hohen Temperaturen als das erste Metall, welches sich darunter befindet. Dadurch wird die Verdampfung des ersten Metalls bzw. der ersten Metalllegierung unterdrückt. In besonders bevorzugten Ausführungsformen wird der Festkörper gekühlt.

Die Unterdrückung der Verdampfung wird umso ausgeprägter, wenn die Ableitung von Wärme nach unten besonders groß ist. Aus diesem Grund wird der Schmelzvorgang vorzugsweise nicht in einem Keramiktiegel, sondern bevorzugt in einem Tiegel mit einer hohen Wärmeleitfähigkeit durchgeführt. Vorzugsweise ist dies ein Graphittiegel oder ein Metalltiegel, insbesondere ein Kupfertiegel. Der Tiegel sollte vorzugsweise eine Wärmeleitfähigkeit von wenigstens 40 W/(m*K), weiter bevorzugt wenigstens 100 W/(m*K), mehr bevorzugt wenigstens 200 W/(m*K) aufweisen. Dies sollte vorzugsweise wenigstens auf den Tiegelboden und insbesondere auch auf die Tiegelwände vorzugsweise wenigstens in deren unterem Bereich zutreffen. Um die Wärmeableitung nach unten weiter zu verstärken, kann der Tiegel im Boden- und/oder Wandbereich mit einem Kühlmittel, wie beispielsweise Wasser, gekühlt werden.

Um die Ableitung der Wärme nach unten zu verstärken, wird der Festkörper vorzugsweise so bereitgestellt, dass das erste Metall bzw. die erste Metalllegierung im Tiegel geschmolzen und wieder erstarren gelassen wird. Alternativ kann auch eine Schmelze des ersten Metalls bzw. der ersten Metalllegierung in den Tiegel gegossen werden, wo die Schmelze dann erstarren kann. Durch die Erstarrung der Schmelze des ersten Metalls bzw. der ersten Metalllegierung im Tiegel wird ein besonders inniger Kontakt zwischen Festkörper und Tiegelwänden und -boden hergestellt, was den Wärmetransport begünstigt. Durch die verbesserte Wärmeleitung wird die Verdampfung des ersten Metalls insbesondere durch Hinauszögern der Schmelze vermindert.

Das erste Metall kann in Form von Granalien, Drähten, Körnern, Pellets, Spänen oder Mischungen daraus in den Tiegel vorgelegt werden. Das erste Metall ist vorzugsweise ein Reaktivmetall, ein Edelmetall oder Aluminium. Besonders bevorzugt sind die Reaktivmetalle. Bevorzugte erste Metalle sind ferner Aluminium, Titan, Gold und Vanadium. Als erste Metalllegierung kommen Legierungen in Frage, welche die vorgenannten ersten Metalle enthalten oder aus ihnen bestehen. Das erste Metall bzw. die erste Metalllegierung weist vorzugsweise einen Schmelzpunkt von weniger als 1.700°C, weiter bevorzugt weniger als 1.200°C und mehr bevorzugt weniger als 800°C auf.

Das zweite Metall wird vorzugsweise in fester Form hinzugefügt, insbesondere in Form von Granalien, Körnern, Drähten, Pellets, Spänen oder Mischungen daraus. Diese kleinteilige Zugabe des zweiten Metalls ermöglicht ein relativ zügiges Aufschmelzen, außerdem ist die Wärmeleitfähigkeit von grobkörnigen Schüttungen relativ gering. Dadurch wird also das allzu schnelle Aufheizen des ersten Metalls bzw. der ersten Metalllegierung unter dem zweiten Metall weiter verzögert. Ferner wird die Prozesszeit insgesamt verkürzt und die Verdampfungsrate des ersten Metalls deutlich abgesenkt. Als positiver Nebeneffekt ist festzustellen, dass die hier in Frage kommenden zweiten Metalle häufig in Form von Partikeln aus Recyclingprozessen gewonnen werden. Beispielsweise werden Tantaldrähte beim Recyceln von Mobiltelefonen erhalten. Eine vorbereitende Behandlung ist also vorzugsweise nicht erforderlich.

Das zweite Metall wird vorzugsweise so auf den Festkörper aufgeschüttet, dass eine möglichst gleichmäßige Bedeckung der Oberfläche des Festkörpers erreicht wird. Bevorzugt ist eine Bedeckung des Festkörpers des ersten Metalls oder der ersten Metalllegierung zu wenigstens 60%, bevorzugt wenigstens 70%, mehr bevorzugt wenigstens 85% und besonders bevorzugt wenigstens 95%. Gemeint ist der Anteil der Oberfläche des Festkörpers. In besonders bevorzugten Ausführungsformen ist der Festkörper vollständig bedeckt.

Es hat sich als vorteilhaft erwiesen, für die Partikel, in deren Form das zweite Metall vorzugsweise hinzugefügt wird, eine mittlere Korngröße zu wählen, die unterhalb von 25 mm, besser unterhalb von 15 mm, bevorzugt unterhalb von 10 mm, weiter bevorzugt unterhalb von 5 mm und ganz besonders bevorzugt unterhalb von 3 mm liegt. Wird eine zu große Korngröße gewählt, muss aufgrund der geringeren spezifischen Oberfläche der Schüttung des zweiten Metalls mit einer längeren Schmelzdauer gerechnet werden. Gleiches gilt bei zu kleiner Korngröße. Kleine Partikel neigen ferner zu elektrostatischer Aufladung, was den Prozess insgesamt stören würde. Daher sollten die Partikel vorzugsweise eine mittlere Korngröße von 200 µm, weiter bevorzugt 400 µm und besonders bevorzugt 1 mm nicht unterschreiten. Mit "Korngröße" ist der lichtmikroskopisch bestimmte Martin-Durchmesser gemeint, also die Länge derjenigen Sehne, die die Partikelprojektionsflächen parallel zur Messrichtung in zwei Hälften teilt.

Es wurde festgestellt, dass die erwähnte kleinteilige Schüttung des zweiten Metalls den Wärmeübergang vom zweiten Metall auf das erste Metall verschlechtert. Erfindungsgemäß bevorzugt erfolgt der Wärmeeintrag von oben auf das zweite Metall, insbesondere mittels einer Elektronenstrahlkanone. Durch den schlechten Wärmeübergang von oben nach unten, schmilzt das erste Metall deutlich später und die Verdampfung wird reduziert.

Das zweite Metall ist vorzugsweise ein Reaktiv- oder Refraktärmetall, also insbesondere ein Metall mit einem Schmelzpunkt gleich oder oberhalb von dem des Titans (1.660°C), insbesondere sogar über 2.000°C. Besonders bevorzugt sind also Titan, Zirconium, Vanadium, Chrom, Hafnium, Niob, Tantal, Molybdän und Wolfram. Besonders bevorzugt sind Tantal, Niob und Titan. In besonderen Ausführungsformen kann auch das erste Metall ein Refraktärmetall sein.

Die Metalle bzw. Metalllegierungen werden vorzugsweise so gewählt, dass deren Schmelzpunkte wenigstens 500°C, weiter bevorzugt wenigstens 750°C, mehr bevorzugt wenigstens 1.000°C und besonders bevorzugt wenigstens 1.200°C auseinander liegen. Das zweite Metall hat den höheren Schmelzpunkt.

Es können auch mehr als zwei Metalle verarbeitet werden. Das dritte und weitere Metalle werden dann abhängig von ihren Schmelzpunkten zusammen mit dem ersten Metall, mit dem zweiten Metall oder dazwischen zugegeben. Vorzugsweise wird mit dem Verfahren eine Legierung aus Tantal und Aluminium, Tantal und Titan oder Niob und Titan hergestellt.

Die Mengenverhältnisse sind abhängig von der gewünschten Legierung. Im Regelfall wird das erste Metall bzw. die erste Metalllegierung in einer größeren Menge eingesetzt als das zweite Metall. Vorzugsweise beträgt die Menge an zweitem Metall im Verhältnis zum ersten Metall wenigstens 5 Gew.-%, bevorzugt wenigstens 10 Gew.-%, weiter bevorzugt wenigstens 20 Gew.-% und besonders bevorzugt wenigstens 30 Gew.-%. Naturgemäß steigt der Schmelzpunkt der herzustellenden Legierung mit dem Gehalt an höher schmelzendem Metall an. Vorzugsweise steigt der Gehalt an zweitem Metall nicht über denjenigen Wert, der zu einem Schmelzpunkt der herzustellenden Legierung führt, welcher mehr als 1000 K oberhalb des Siedepunkts des ersten Metalls liegt.

Vorzugsweise beträgt der Anteil an zweitem Metall im Verhältnis zum ersten Metall höchstens 50 Gew.-%, weiter bevorzugt höchstens 40 Gew.-%. Die Zusammensetzung der hergestellten Legierung kann durch Zugabe weiterer Metalle oder anderer Dotanden eingestellt werden. Vorzugsweise macht die Summe von erstem Metall bzw. erster Metalllegierung und zweitem Metall wenigstens 75 Gew.-%, weiter bevorzugt wenigstens 85 Gew.-%, mehr bevorzugt wenigstens 95 Gew.-% und besonders bevorzugt wenigstens 99 Gew.-% der hergestellten Legierung aus.

In einer Ausführungsform liegt der Siedepunkt des ersten Metalls bzw. der ersten Metalllegierung niedriger als der Schmelzpunkt des zweiten Metalls. Wenn in dieser Anmeldung von "Siedepunkt" oder "Schmelzpunkt" die Rede ist, so bezeichnen diese Temperaturpunkte die Eigenschaften des jeweiligen Materials unter Standardbedingungen (DIN 1343, nämlich bei einem Druck von 101,325 kPa). Wenn in dieser Anmeldung von "Metall" die Rede ist, so umfasst der Begriff auch Metalllegierungen.

Mit dem erfindungsgemäßen Verfahren lässt sich der Verdampfungsverlust an dem niedriger schmelzenden Metall auf einen niedrigen einstelligen Prozentbetrag vermindern. Vorzugsweise beträgt der Verdampfungsverlust am ersten Metall bzw. an der ersten Metalllegierung höchstens 5 Gew.-%, weiter bevorzugt höchstens 3 Gew.-% bezogen auf das erste Metall bzw. auf die erste Metalllegierung.

Mit dem erfindungsgemäßen Verfahren lassen sich Legierungen herstellen, die einen Sauerstoffanteil von weniger als 400 ppm, weiter bevorzugt weniger als 200 ppm und besonders bevorzugt weniger als 100 ppm aufweisen. Dies ist selbst mit recyceltem Ausgangsmaterial möglich.

In dem erfindungsgemäßen Verfahren werden die Ausgangskomponenten im Tiegel auf eine Temperatur erhitzt, die wenigstens dem Schmelzpunkt der herzustellenden Legierung entspricht.

Wie sich aus der Beschreibung insgesamt ergibt, umfasst das erfindungsgemäße Verfahren auch das Schmelzen des ersten Metalls bzw. der ersten Metalllegierung, das Herstellen einer Legierung aus dem geschmolzenen Material und die Entnahme der Legierung aus dem Tiegel.

### Beispiel

In einem Knopftiegel wird zuerst Aluminium in Form von Granalien vorgelegt. Diese werden mit kleiner Leistung mittels einer Elektronenstrahlkanone aufgeschmolzen und zu einem massiven Knopf konsolidiert. Wider Erwarten erwiesen sich die Verdampfungsverluste als sehr gering, nämlich weniger als 3 %.

Der erhaltene Knopf hat einen sehr guten Kontakt zur kalten Tiegelwand und entsprechend hohe Wärmeleitung. Die Oberfläche des Knopfes wird mit Tantaldrähten abgedeckt. Diese Schüttung hat im Vergleich zum Aluminiumblock eine sehr schlechte Wärmeleitung, wodurch sich beim anschließenden Aufheizen der Tantalschicht diese bis nahe an ihre Schmelztemperatur aufheizt und erst dann durch Wärmeleitung das Aluminium verflüssigt und sich mit der Tantalschicht vermischt.

Erstaunlicherweise wurde bei diesem Schmelzversuch eine Abdampfung von Aluminium von weniger als 1 % gefunden.

## Patentansprüche

1. Verfahren zur Herstellung einer Metalllegierung enthaltend wenigstens zwei Metalle, umfassend die Schritte:
• Bereitstellen eines Festkörpers eines ersten Metalls oder einer ersten Metalllegierung in einem Tiegel,
• Hinzufügen eines zweiten Metalls auf den Festkörper im Tiegel,
• Schmelzen des zweiten Metalls,
**dadurch gekennzeichnet, dass** der Schmelzpunkt des zweiten Metalls höher ist als der Schmelzpunkt des ersten Metalls beziehungsweise der ersten Metalllegierung und wenigstens das Schmelzen des zweiten Metalls unter Vakuum stattfindet.

2. Verfahren nach Anspruch 1, wobei das Bereitstellen des Festkörpers folgende Schritte umfasst:
• Einbringen des ersten Metalls oder der ersten Metalllegierung in den Tiegel,
• Schmelzen des ersten Metalls beziehungsweise der ersten Metalllegierung,
• Erstarrenlassen der Schmelze des ersten Metalls beziehungsweise der ersten Metalllegierung zu dem Festkörper.

3. Verfahren nach Anspruch 1 oder 2, wobei das zweite Metall in fester Form hinzugefügt wird.

4. Verfahren nach einem der Ansprüche 1 bis 3, wobei das zweite Metall in Form von Granalien, Körnern, Drähten, Pellets, Spänen oder Mischungen daraus hinzugefügt wird.

5. Verfahren nach wenigstens einem der vorhergehenden Ansprüche, wobei das zweite Metall in mittleren Korngrößen von weniger als 25 mm hinzu gefügt wird.

6. Verfahren nach wenigstens einem der vorhergehenden Ansprüche, wobei das Schmelzen unter Vakuum von weniger als 100 mbar absolut durchgeführt wird.

7. Verfahren nach wenigstens einem der vorhergehenden Ansprüche, wobei als Wärmequelle eine Elektronenstrahlkanone verwendet wird.

8. Verfahren nach wenigstens einem der vorhergehenden Ansprüche, wobei der Tiegel eine Wärmeleitfähigkeit von wenigstens 40 W/(m*K) aufweist.

9. Verfahren nach wenigstens einem der vorhergehenden Ansprüche, wobei der Schmelzpunktunterschied zwischen zweitem Metall und erstem Metall beziehungsweise erster Metalllegierung wenigstens 500°C beträgt.

10. Verfahren nach wenigstens einem der vorhergehenden Ansprüche, wobei der Verdampfungsverlust an dem ersten Metall beziehungsweise der ersten Metalllegierung höchstens 5 Gew.-% beträgt.

## Claims

1. A method for preparing a metal alloy containing at least two metals, comprising the steps of:
• providing a solid of a first metal or a first metal alloy in a crucible,
• adding a second metal onto the solid in the crucible,
• melting the second metal,
**characterized in that** the melting point of the second metal is higher than the melting point of the first metal or the first metal alloy and that at least the melting of the second metal takes place under vacuum.

2. The method according to claim 1, wherein the provision of the solid comprises the following steps:
• introducing the first metal or the first metal alloy into the crucible,
• melting the first metal or the first metal alloy,
• allowing the melt of the first metal or the first metal alloy to solidify to the solid.

3. The method according to claim 1 or 2, wherein the second metal is added in solid form.

4. The method according to one of claims 1 to 3, wherein the second metal is added in the form of granules, grains, wires, pellets, chips or mixtures thereof.

5. The method according to at least one of the preceding claims, wherein the second metal is added in mean grain sizes of less than 25 mm.

6. The method according to at least one of the preceding claims, wherein the melting is conducted under vacuum of an absolute pressure of lower than 100 mbar.

7. The method according to at least one of the preceding claims, wherein an electron beam gun is used as heat source.

8. The method according to at least one of the preceding claims, wherein the crucible has a thermal conductivity of at least 40 W/(m*K).

9. The method according to at least one of the preceding claims, wherein the difference between the melting points of the second metal and the first metal or the first metal alloy is at least 500°C.

10. The method according to at least one of the preceding claims, wherein the loss of evaporation of the first metal or the first metal alloy is at most 5 % by weight.

## Revendications

1. Procédé pour la production d'un alliage métallique contenant au moins deux métaux, comprenant les étapes suivantes :
- la fourniture d'un solide d'un premier métal ou d'un premier alliage métallique dans un creuset,
- l'ajout d'un deuxième métal sur le solide dans le creuset,
- la fusion du deuxième métal,
**caractérisé en ce que** le point de fusion du deuxième métal est plus élevé que le point de fusion du premier métal ou du premier alliage métallique et au moins la fusion du deuxième métal s'effectue sous vide.

2. Procédé selon la revendication 1, dans lequel la fourniture du solide comprend les étapes suivantes :
- l'introduction du premier métal ou du premier alliage métallique dans le creuset,
- la fusion du premier métal ou du premier alliage métallique,
- la solidification de la masse fondue du premier métal ou du premier alliage métallique pour donner le solide.

3. Procédé selon la revendication 1 ou 2, dans lequel le deuxième métal est ajouté sous une forme solide.

4. Procédé selon l'une des revendications 1 à 3, dans lequel le deuxième métal est ajouté sous la forme de granules, de grains, de fils, de pellets, de copeaux ou de mélanges de ceux-ci.

5. Procédé selon au moins une des revendications précédentes, dans lequel le deuxième métal est ajouté avec une granulométrie moyenne de moins de 25 mm.

6. Procédé selon au moins une des revendications précédentes, dans lequel la fusion est réalisée sous vide à moins de 100 mbars de manière absolue.

7. Procédé selon au moins une des revendications précédentes, dans lequel un canon à faisceau d'électrons est utilisé en tant que source de chaleur.

8. Procédé selon au moins une des revendications précédentes, dans lequel le creuset présente une conductivité thermique d'au moins 40 W/(m*K).

9. Procédé selon au moins une des revendications précédentes, dans lequel la différence de point de fusion entre le deuxième métal et le premier métal ou le premier alliage métallique est au moins de 500 °C.

10. Procédé selon au moins une des revendications précédentes, dans lequel la perte par évaporation au niveau du premier métal ou du premier alliage métallique est de 5 % en poids tout au plus.
